Europäisches Patentamt

European Patent Office

Office européen des brevets

(19)

(11) Veröffentlichungsnummer: **0 232 749**

**A2**

(12) **EUROPÄISCHE PATENTANMELDUNG**

(21) Anmeldenummer: **87100619.3**

(22) Anmeldetag: **19.01.87**

(51) Int. Cl.4: **H01L 27/14 , H01L 31/02**

(30) Priorität: **30.01.86 DE 3602798**

(43) Veröffentlichungstag der Anmeldung:
**19.08.87 Patentblatt 87/34**

(84) Benannte Vertragsstaaten:
**DE FR GB**

(71) Anmelder: **Siemens Aktiengesellschaft Berlin und München**
**Wittelsbacherplatz 2**
**D-8000 München 2(DE)**

(72) Erfinder: **Stetter, Walter, Dipl.-Ing. (FH)**
**Am Lichtcker 1**
**D-7919 Tiefenbach(DE)**
Erfinder: **Peters, Winfried, Dipl.-Phys.**
**Tizianstrasse 16**
**D-8014 Neubiberg(DE)**

(54) **Verfahren zur integrierten Serienverschaltung von Dünnschichtsolarzellen.**

(57) Zur Serienverschaltung einer Vielzahl von Dünn-schicht-Solarzellen werden nach einem vorher aufge-brachten Streifenmuster (4) aus vorzugsweise Kunst-stoff Trenngräben (5) in der, auf den mit den Front-Elektroden (2) versehenen Substrat (1) aufgebrach-ten Dünnschicht (3) auf mechanischem Wege er-zeugt, dann ganzflächig die Metallisierung (6) für die Rückelektroden (8) durchgeführt, wobei die Trenngräben (5) mit Metall (6) aufgefüllt werden und anschließend durch Abhebetechnik das Streifenmu-ster (4) entfernt, wobei an den vorher mit diesem Streifenmuster (4) bedeckten Stellen der Dünn-schichtoberfläche (3) Trenngräben (7) für die Rückelektroden (8) gebildet werden. Das Verfahren ist einfach ausführbar, läßt sich in den Solarzellen-prozeß leicht integrieren und hat keine flächenmäßige Begrenzung. Der Wirkungsgrad der Solarzellen wird durch die Serienverschaltung nicht verschlechtert. Das Verfahren dient der Herstellung großflächiger Panele für photovoltaische Module.

FIG 4

FIG 6

## Verfahren zur integrierten Serienverschaltung von Dünnschicht-Solarzellen.

Die Erfindung betrifft ein Verfahren zur integrierten Serienverschaltung einer Vielzahl von auf einem gemeinsamen isolierenden, transparenten Substrat angeordneten photovoltaischen Dünnschicht-Solarzellen, bei dem zur Herstellung der elektrisch-leitenden Verbindungen zwischen den einzelnen Solarzellen in die Dünnschicht Trenngräben eingebracht und bei der Herstellung der Rück-Elektroden mit Metall aufgefüllt werden, so daß die auf dem Substrat aufgebrachte Front-Elektrode der einen Zelle mit der durch Metallisierung hergestellten Rück-Elektrode der benachbarten Zelle verbunden wird.

Eine solche Solarzellenanordnung ist beispielsweise aus dem US-Patent 4.517.403 zu entnehmen.

Ein Hauptproblem sowohl bei der Herstellung der Solarzellenanordnung als auch im späteren Einsatz ist die Kontaktierung der Solarzellen untereinander. Üblicherweise wird die jeweils n-leitende Zone der einen Solarzelle mit der p-leitenden Zone der benachbarten Solarzelle mittels Kontaktverbindern aus Metall, zum Beispiel aus Silber, elektrisch leitend verbunden. Bei Solarzellen aus einkristallinem Silizium erfolgt meist eine externe Einzelverdrahtung der Zellen, wodurch ein wesentlicher Arbeitsaufwand entsteht.

Dünnschicht-Solarzellen aus zum Beispiel amorphem Silizium (a-Si:H = amorphes Silizium mit gebundenen Wasserstoffatomen) können auf isolierenden Trägern erzeugt werden. Durch die geringe Leitfähigkeit der transparenten Frontelektrode müssen bei der Herstellung von großen Modulflächen zur Vermeidung von Wirkungsgradeinbußen und zur Erhöhung der Modulspannung mehrere kleine Einzelzellen serienverschaltet werden, was durch das gemeinsame Grundsubstrat sehr leicht möglich wird. Es werden streifenförmige Zellen mit Betriebsspannungen von zum Beispiel ca. 0.7 V gebildet. Damit können nun Zellen mit Betriebsspannungen von zum Beispiel 12 V/24 V, also serienverschaltet, im Arbeitsablauf der Zellenfertigung hergestellt werden.

Das Problem besteht nun darin, die Serienverschaltung in möglichst einfacher Weise mit der Zellenherstellung zu verbinden, ohne daß der Wirkungsgrad der Solarzelle beeinträchtigt wird.

Es ist Aufgabe der Erfindung, dieses Problem zu lösen.

Von der Fifth E. C. Photovoltaic Solar Energy Conference, Proceedings Kavouri, Greece, im Oktober 1983, Seiten 712 bis 716, sowie von der 17. IEEE Photovoltaic Conference Orlando 1984, Seiten 206 bis 211, ist bekannt, zur Serienverschaltung von solchen Dünnschicht-Solarzellen ein selektives Laser-Trennverfahren zu verwenden. Bei dem auch als Laser-Scribing bekannten Verfahren bereitet die selektive Durchtrennung der amorphen Siliziumschicht und die anschließende selektive Durchtrennung der Metallisierung große technische Schwierigkeiten. Außerdem sind Verfahren mit Laseranlagen sehr kostenintensiv.

Die Erfindung beschreibt einen anderen und weniger aufwendigen Weg zur Lösung des oben angegebenen Problems und ist durch ein Verfahren der eingangs genannten Art dadurch gekennzeichnet, daß

a) in entsprechend der Größe der Solarzellen bestimmten Abständen auf die Dünnschicht ein Streifenmuster aus einem in Lösungsmitteln leicht löslichen oder von der Dünnschichtoberfläche leicht entfernbaren Material so aufgebracht wird, daß es seitlich versetzt zu den unter der Dünnschichtsolarzelle liegenden Frontelektroden ist und die Bereiche der Dünnschicht bedeckt, die von den später zu erzeugenden Rückelektroden nicht bedeckt werden,

b) auf mechanischem Wege entsprechend dem Streifenmuster seitlich versetzt dazu Trenngräben in der Dünnschichtsolarzelle erzeugt werden,

c) eine ganzflächige Metallisierung durchgeführt wird, und

d) das Streifenmuster durch Abhebetechnik entfernt wird, wobei die selektive Trennung der Rückelektroden erfolgt.

Es liegt im Rahmen der Erfindung, das Streifenmuster so aufzubringen, daß es seitlich versetzt zu den unter der Dünnschichtsolarzelle liegenden Frontelektroden um den Betrag der Trenngrabenbreite liegt.

Weitere Ausgestaltungen der Erfindung ergeben sich aus den Unteransprüchen.

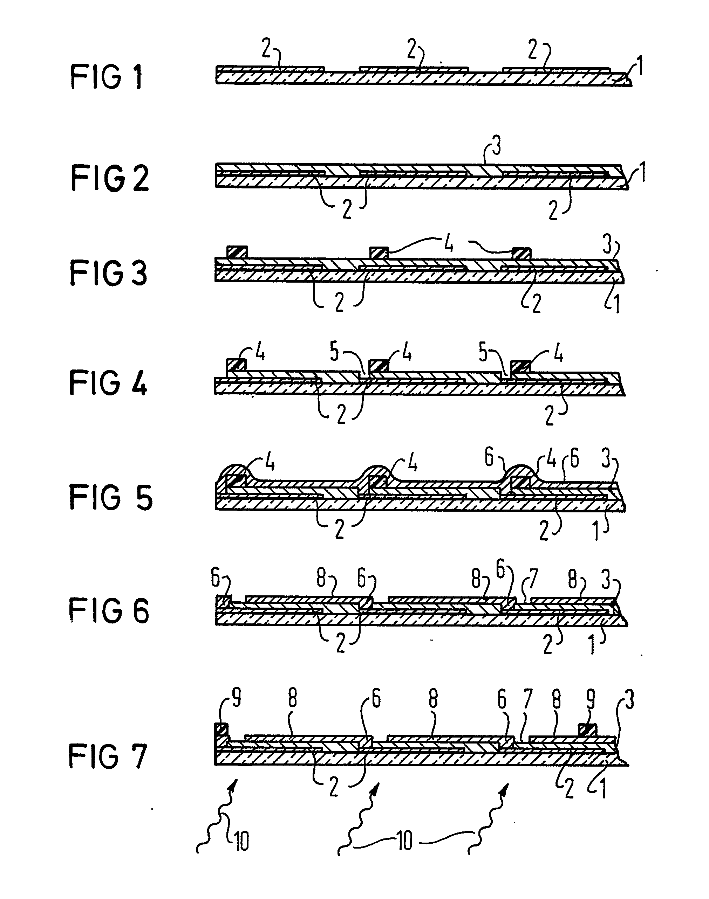

Nachfolgend wird anhand eines Ausführungsbeispiels und der Figuren 1 bis 7, die im Schnittbild den Arbeitsablauf zur Herstellung einer Solarzellenanordnung mit integrierter Serienverschaltung darstellen, das Verfahren nach der Lehre der Erfindung noch näher beschrieben.

Figur 1: Auf ein transparentes, zum Beispiel aus Glas oder Kunststoff bestehendes Substrat 1, welches massiv oder auch als Folie vorliegen kann, wird eine transparente leitende Oxidschicht (TCO = transparent conducting oxide) aus zum Beispiel dotiertem Zinnoxid aufgebracht und in bekannter Weise so strukturiert, daß die Front-Elektroden 2 entstehen.

Figur 2: Diese Anordnung (1, 2) wird ganzflächig mit einer Dünnschichtsolarzelle 3 versehen, die beispielsweise aus einer amorphen Silizium (a-Si:H) pin-Struktur besteht, die durch Plasmaabscheidung aus Silan mit den entsprechenden Dotierstoffen hergestellt wird.

Figur 3: Auf die Dünnschichtoberfläche 3 wird für die spätere Abhebetechnik (siehe Figur 6) ein Streifenmuster 4, zum Beispiel aus einer selbstklebenden Kunststoff-Folie, so aufgebracht, daß es seitlich versetzt zu den unter der Dünnschichtsolarzelle 3 liegenden Frontelektrode 2 um den Betrag der Breite der einzubringenden Trenngräben (5) liegt. Anstelle des Kunststoffstreifens 4 können auch Lack-oder Ölmuster (mit mechanischen Vorrichtungen) aufgebracht oder ein Siebdruckverfahren angewandt werden.

Figur 4: Nun erfolgt das selektive mechanische Trennen der Dünnschicht-Solarzellen ohne Verletzung der Frontelektroden 2 durch Fräsen von Gräben 5 in die Dünnschicht 3 mittels feinster Fräser, wobei sich die Flächenverluste in sehr geringen Grenzen halten. Durch die gute Haftung und die Härte der Frontelektrodenschicht 2 läßt sich die Dünnschicht von der darunterliegenden TCO-Schicht 2 sehr leicht selektiv trennen. Der Flächenverlust liegt in der Größenordnung von 5 % (500 μm bei 10 mm Zellenbreite). Anstelle von Fräsen können auch Schleif-, Sandstrahl-, Säge- oder Hobelprozesse verwendet werden.

Figur 5: Auf die mit den Trenngräben 5 versehene Anordnung 1, 2, 3, 4 wird nun ganzflächig eine aus zum Beispiel Aluminium oder Silber bestehende Metallschicht 6, vorzugsweise durch Aufdampfen oder Kathodenzerstäubung, aufgebracht, wobei durch Auffüllen der Gräben 5 mit Metall 6 die Frontelektrode 2 der einen Zelle mit der späteren Rückelektrode 8 der anderen Zelle elektrisch leitend verbunden wird.

Figur 6: Durch Abziehen bzw. Abheben des Streifenmusters 4, zum Beispiel durch Behandlung in einem organischen Lösungsmittel (eventuell unter Einwirkung von Ultraschall), wird nun die Metallschicht 6 an den Stellen entfernt (das heißt mit abgehoben), an denen die Metallschicht 6 mit dem Streifenmuster 4 in Kontakt war. Auf diese Weise entstehen Trenngräben 7 in der Metallisierung und die Rückelektroden 8 der Solarzellenanordnung werden aus der Metallisierung gebildet. Gleichzeitig findet die Serienverschaltung statt.

Figur 7 zeigt das Aufbringen der Außenkontakte 9. Mit den Pfeilen 10 ist das einfallende Licht bezeichnet.

Das Verfahren nach der Lehre der Erfindung eignet sich sehr gut sowohl für glatte als auch vor allem für rauhe TCO-Oberflächen und hat keine flächenmäßige Begrenzung. Die Schrittgeschwindigkeit beim mechanischen Trennen der Dünnschicht liegt bei ca. 10 cm/sec.

Durch das beschriebene Verfahren der Serienverschaltung wird der Wirkungsgrad der Dünnschicht-Solarzellen, der derzeit bei 8 bis 10 % liegt, nicht beeinträchtigt.

Bezugszeichenliste

    1 Glas-Substrat
    2 Front-Elektroden
    3 Dünnschichtsolarzelle
    4 Kunststoff-Folie
    5 Gräben
    6 Metallschicht
    7 Gräben
    8 Rück-Elektroden
    9 Außenkontakte
    10 Lichteinfall

**Ansprüche**

1. Verfahren zur integrierten Serienverschaltung einer Vielzahl von auf einem gemeinsamen isolierenden, transparenten Substrat (1) angeordneten photovoltaischen Dünnschichtsolarzellen, bei dem zur Herstellung der elektrisch-leitenden Verbindungen zwischen den einzelnen Solarzellen in die Dünnschicht (3) Trenngräben (5) eingebracht und bei der Herstellung der Rück-Elektroden (8) mit Metall (6) aufgefüllt werden, so daß die auf dem Substrat (1) aufgebrachte Front-Elektrode (2) der einen Zelle mit der durch Metallisierung hergestellten Rück-Elektrode (8) der benachbarten Zelle verbunden wird, **dadurch gekennzeichnet, daß**

a) in entsprechend der Größe der Solarzellen bestimmten Abständen auf die Dünnschicht (3) ein Streifenmuster (4) aus einem in Lösungsmittel leicht löslichen oder von der Dünnschichtoberfläche leicht entfernbaren Material so aufgebracht wird, daß es seitlich versetzt zu den unter der Dünnschichtsolarzelle (3) liegenden Frontelektroden (2) ist und die Bereiche der Dünnschicht (3) bedeckt, die von den später zu erzeugenden Rückelektroden (8) nicht bedeckt werden,

b) auf mechanischem Wege entsprechend dem Streifenmuster (4) seitlich versetzt dazu Trenngräben (5) in der Dünnschichtsolarzelle (3) erzeugt werden,

c) eine ganzflächige Metallisierung (6) durchgeführt wird, und

d) das Streifenmuster (4) durch Abhebetechnik entfernt wird, wobei die selektive Trennung (7) der Rückelektroden (8) erfolgt.

2. Verfahren nach Anspruch 1, **dadurch gekennzeichnet, daß** das Streifenmuster (4) so aufgebracht wird, daß es seitlich versetzt zu den unter der Dünnschichtsolarzelle (3) liegenden Frontelektroden (2) um den Betrag der Trenngrabenbreite - (5) ist.

3. Verfahren nach Anspruch 1 und/oder 2, **dadurch gekennzeichnet,** daß die Dünnschichtsolarzelle (3) durch Abscheidung von amorphem Silizium erzeugt wird.

4. Verfahren nach mindestens einem der Ansprüche 1 bis 3, **dadurch gekennzeichnet,** daß die Trenngräben (5) in der Dünnschicht (3) durch Fräsen, Schleifen, Sandstrahlen, Sägen oder Hobeln erzeugt werden.

5. Verfahren nach mindestens einem der Ansprüche 1 bis 4, **dadurch gekennzeichnet,** daß als Material für das Streifenmuster (4) selbstklebende Kunststoff-Folien, Lacke oder Öle verwendet werden.

6. Verfahren nach mindestens einem der Ansprüche 1 bis 5, **dadurch gekennzeichnet,** daß das Streifenmuster (4) durch Siebdruck-Technik hergestellt wird.

7. Verfahren nach mindestens einem der Ansprüche 1 bis 6, **dadurch gekennzeichnet,** daß das Streifenmuster (4) durch Ablösen, Abwaschen oder Abziehen entfernt wird.

8. Verfahren nach Anspruch 7, **dadurch gekennzeichnet,** daß das Ablösen oder Abwaschen im Ultraschallbad erfolgt.

9. Verfahren nach mindestens einem der Ansprüche 1 bis 8, **dadurch gekennzeichnet,** daß die Dünnschichtsolarzelle als Tandem-oder Mehrfachzelle übereinander erzeugt wird.

10. Solarzellen-Anordnung, die aus einer Vielzahl photovoltaischer Dünnschicht-Solarzellen aus Halbleitermaterial besteht, bei der die Zellen auf einem isolierenden, transparenten, auf der Lichteinfallsseite (10) liegenden Substrat (1) aufgebracht sind und durch integrierte Serienverschaltung (2, 6, 8) elektrisch-leitend miteinander verbunden sind, hergestellt nach einem Verfahren nach mindestens einem der Ansprüche 1 bis 9.

0 232 749

FIG 1

FIG 2

FIG 3

FIG 4

FIG 5

FIG 6

FIG 7